# EUROPÄISCHE PATENTSCHRIFT

(11) **EP 1 927 610 B1**
(45) Veröffentlichungstag und Bekanntmachung des Hinweises auf die Patenterteilung: **25.11.2009**
(21) Anmeldenummer: 08004400.1
(22) Anmeldetag: 12.08.2004
(51) Int. Cl.: C08G 61/00, H01L 51/30, C09D 5/24, H01B 1/12

(54) **Prozeß zur Herstellung von Aryl- oder Heteroarylamin-Boronsäurederivaten**
Process for the synthesis of aryl- or heteroarylamine boronic acid derivatives
Procédé pour la synthèse de dérivés aryl- ou hétéroarylamine de l'acide boronique

(30) Priorität: 12.08.2003 DE 10337077
(43) Veröffentlichungstag der Anmeldung: 04.06.2008
(62) Teilanmeldung aus: 04764022.2
(73) Patentinhaber: Merck Patent GmbH, 64293 Darmstadt (DE)
(72) Erfinder: Becker, Heinrich, Dr., 65719 Hofheim (DE); Breuning, Esther, Dr., 65527 Niedernhausen (DE); Ludemann, Aurélie, Dr., 60322 Frankfurt (DE); Parham, Amir, Dr., 65929 Frankfurt (DE)

(56) Entgegenhaltungen:
- EP-A- 0 802 173
- US-A- 5 576 460
- US-A1- 2004 024 237
- READ, ESCOBEDO, WILLIS, BECK, STRONGIN: "Convenient iterative synthesis of an octameric tetracarboxylate-functionalized Oligophenylene Rod with divergent endgroups" ORGANIC LETTERS, Bd. 2, Nr. 20, 2. September 2000 (2000-09-02), - 2000 Seiten 3201-3204, XP002477967

## Beschreibung

Seit ca. 12 Jahren läuft eine breit angelegte Forschung zur Kommerzialisierung von Anzeige- und Beleuchtungselementen auf Basis polymerer (organischer) Leuchtdioden (PLEDs). Ausgelöst wurde diese Entwicklung durch die Grundlagenentwicklungen, welche in EP 423283 (WO 90/13148) offenbart sind. Seit kurzem ist auch ein erstes Produkt in Form einer kleineren Anzeige (in einem Rasierapparat der Fa. PHILIPS N.V.) auf dem Markt erhältlich. Allerdings sind immer noch deutliche Verbesserungen nötig, um diese Displays zu einer echten Konkurrenz zu den derzeit Markt beherrschenden Flüssigkristallanzeigen (LCD) zu machen bzw. diese zu überflügeln. Vor allem ist es hierbei erforderlich, Polymere für alle Emissionsfarben (Rot, Grün, Blau) zur Verfügung zu stellen, die den Anforderungen des Marktes (Effizienz, operative Lebensdauer, Betriebsspannung, um die wichtigsten zu nennen) gerecht werden.

Als Polymere für vollfarbige Anzeigeelemente (sog. Full-Colour-Displays) wurden bereits verschiedene Materialklassen vorgeschlagen bzw. entwickelt. So kommen Polyfluoren-Derivate, wie beispielsweise in EP 0842208, WO 99/54385,
WO 00/22027, WO 00/22026 und WO 00/46321 offenbart, in Betracht. Des Weiteren sind auch Polyspirobifluoren-Derivate, wie in EP 0707020, EP 0894107 und WO 03/020790 offenbart, eine Möglichkeit. Auch Polymere, die eine Kombination der beiden erstgenannten Strukturelemente enthalten, wie in
WO 02/077060 offenbart, wurden bereits vorgeschlagen. Im Allgemeinen sind für derartigen Einsatz Polymere, welche Poly-para-phenylen (PPP) als Strukturelement enthalten, möglich. Neben den oben bereits genannten Klassen kommen hier beispielsweise auch die so genannten Leiter-PPPs ("Ladder-PPPs" = L-PPP) (z. B. gemäß WO 92/18552), die Poly-tetrahydropyrene (z. B. gemäß EP 699699), aber auch Ansa-Strukturen enthaltende PPPs (z. B. gemäß EP 690086) in Frage.

Wie in einigen der o. g. Anmeldeschriften bereits herausgearbeitet wurde, ist es für die Erzeugung aller drei Emissionsfarben notwendig, bestimmte Comonomere in die entsprechenden Polymere einzupolymerisieren (z. B. WO 00/46321, WO 03/020790 und WO 02/077060). So ist dann - ausgehend von einem blau emittierenden Polymergrundgerüst ("backbone") - die Erzeugung der beiden anderen Primärfarben Rot und Grün möglich.
Des Weiteren wurde berichtet, dass das Einfügen bestimmter Arylamino-Gruppierungen eine Verbesserung der Eigenschaften ergibt: WO 99/54385 und DE 19846767 beschreiben Polyfluorene, deren Effizienz und Einsatzspannung verbessert werden können, indem Derivate von Triphenylamin, Tetraphenyl-p-diaminobenzol, Tetraphenyl-4,4'-diaminobiphenyl oder substituierte Diarylaminoeinheiten in die Hauptkette der entsprechenden Polymere mit einpolymerisiert werden. WO 01/66618 beschreibt Copolymere, welche neben Aryleinheiten auch spezielle Triaryiamino- bzw. Tetraaryl-p-diaminoarylen-Einheiten in der Hauptkette enthalten. In der nicht offen gelegte Anmeldung DE 10304819.7 wird beschrieben, dass die Verwendung bestimmter Carbazoleinheiten in verringerter Betriebsspannung resultiert. Die nicht offen gelegte Anmeldung EP 03012409.3 beschreibt die Verwendung von Oligo-Triarylamin-Einheiten.

Trotz der in den o. g. Anmeldeschriften zitierten Fortschritte gibt es auf folgenden Feldern immer noch einen erheblichen Verbesserungsbedarf für entsprechende Materialien:
- Die operative Lebensdauer, v. a. bei blau emittierenden Polymeren, bedarf immer noch einer deutlichen Verbesserung, um diese für langlebige Anwendungen einsetzen zu können.
- Die Effizienz ist noch deutlich verbesserungsbedürftig. Dies ist vor allem für mobile Anwendungen von großer Bedeutung.
- Die Betriebsspannung muss noch weiter reduziert werden, damit für Anwendungen große Helligkeit bei ausreichend niedrigen Spannungen erzielt werden kann und somit eine höhere Leistungseffizienz erzielt wird. Dies ist von enormer Bedeutung, da somit einerseits gleiche Helligkeit bei geringerem Energieverbrauch erzielt werden kann, was vor allem bei mobilen Applikationen (Displays für Handys, Pager, PDA, etc.), die auf Batterien und Akkus angewiesen sind, sehr wichtig ist. Andererseits erhält man bei gleichem Energieverbrauch höhere Helligkeiten, was beispielsweise für Beleuchtungsanwendungen interessant sein kann,

Copolymere aus zwei oder mehr unterschiedlichen Monomeren können prinzipiell verschiedenartig aufgebaut sein:
- In alternierenden Copolymeren alternieren die beiden (oder auch drei oder mehr) Wiederholeinheiten.
- In statistischen Copolymeren ist die Sequenz der Bausteine durch die bei der Polymerisation vorhandenen statistischen Gesetzmäßigkeiten gegeben.
- In teilstatistischen Copolymeren im Sinne dieser Erfindung ist die Anordnung einer der Wiederholeinheiten definiert, während die anderen Wiederholeinheiten statistisch angeordnet sind. Solche Copolymere werden beispielsweise durch Reaktion eines Monomeren A mit zwei Monomeren B und B' erhalten, wobei sowohl B als auch B' nur mit A, nicht aber mit B oder B' reagieren kann.
- Block-Copolymere bestehen aus Blöcken von Homosequenzen bzw. aus Blöcken von definierten Sequenzen, die über die Enden miteinander verknüpft sind. Die Verknüpfung der Blöcke kann auch über mitteiständige Kettenglieder erfolgen. In diesem Fall erhält man Pfropf-Copolymere.
- Es können in einem Polymer auch verschiedene dieser Strukturmerkmale kombiniert werden. So können beispielsweise Blöcke über statistische oder teilstatistische Sequenzen verknüpft werden ("tapered copolymer").

In WO 00/55927 werden Copolymere beschrieben, die aus zwei oder mehr Regionen im Polymergrundgerüst bestehen. Dabei dient die erste Region dem Transport negativer Ladungsträger, die zweite Region dem Transport positiver Ladungsträger, während in der dritten Region positive und negative Ladungsträger unter Erzeugung von Licht rekombinieren. Dabei bezeichnet der Begriff "Region" ein Segment der Polymerkette, das aus einem oder mehreren Monomeren bestehen, kann. Die Anordnung und das Verhältnis der Monomere im Polymer sind so gewählt, dass sich die Bandlücken der einzelnen Regionen im Polymer unterscheiden. Es wird beschrieben, dass die einzelnen Komponenten in der Hauptkette, in der Seitenkette, als Block-Copolymere oder als statistische Polymere kombiniert werden können. Jedoch wird nur die Synthese statistischer oder alternierender Copolymere beschrieben, und in den Beispielen werden nur teilstatistische oder alternierende Copolymere, jedoch keine Block-Copolymere, vorgestellt, Es wird auch kein Vorzug von Block-Copolymeren gegenüber statistischen Polymeren erwähnt, so dass nicht offensichtlich ist, wie brauchbare Blockpolymere hergestellt werden könnten, und die Vermutung nahe liegt, dass Block-Copolymere hier nur zufällig aufgeführt sind.

EP 1149827 beschreibt Polyfluorene mit einer Blockstruktur der allgemeinen Zusammensetzung
Endcapper1-(Fluoren)ₘ-(L)ₚ-(Fluoren)ₙ-(M)ₛ-(Fluoren)ₒ-Endcapper2,
wobei L und M beliebige aromatische Monomere darstellen, mit der Vorgabe, dass m+n+o ≥ 10 ist, dass p und s im Bereich von 0 bis 15 ist und dass mindestens einer der beiden Endcapper Ladungstransporteigenschaften zeigt. Besondere Vorzüge eines solchen Polymers mit blockartigen Unterstrukturen werden nicht genannt. Auch wird kein Beispiel für ein solches blockartiges Polymer aufgeführt, ebenso wenig eine Synthesemethode dafür, und als bevorzugte Strukturen werden Polymere genannt, in denen m, p, s und o = 0 ist, die also nur Fluoreneinheiten aufweisen und somit keine Block-Copolymere sind. Dies lässt vermuten, dass die blockartige Struktur hier nur zufällig aufgeführt ist. Insbesondere ist auch für den Fachmann nicht nachvollziehbar, wie sich solche Blockpolymere synthetisieren lassen, da Polykondensationsprozesse, wie sie für diese Art von Polymeren üblicherweise angewendet werden und auch in den Beispielen aufgeführt sind, immer zu Mischungen und nicht zu klar definierten Polymeren führen, die genau drei Oligofluoren-Segmente besitzen, die über zwei (oligo)aromatische Segmente verbrückt sind.

WO 02/088223 beschreibt die Synthese und Verwendung konjugierter Block-Copolymere, die zwei oder mehr Blöcke enthalten, die gleich oder verschieden sein können, die eine oder mehrere Wiederholeinheiten haben können und die direkt oder über eine Zwischeneinheit miteinander verbunden sein können.

WO 03/007395 beschreibt konjugierte Block-Copolymere, die aus einem Emitter-Block und mindestens einem weiteren Block, der ein Ladungstransport-Block oder ein Host-Polymer-Block sein kann, bestehen. Als Vorteile dieser Polymere wird angegeben, dass diese bessere Eigenschaften in Elektrolumineszenzvorrichtungen zeigen, verglichen mit statistischen Copolymeren oder Blends statistischer Polymere, insbesondere hinsichtlich der Helligkeit, der Leistungseffizienz und der Lebensdauer. Als Beispiele werden allerdings nur Polymere aufgeführt, deren Blöcke teilstatistisch oder alternierend sind. Homoblöcke oder statistische Abschnitte werden nicht vorgestellt. Vergleicht man die Block-Copolymere mit den in den Vergleichsbeispielen angegebenen teilstatistischen Polymeren, so scheinen die Block-Copolymere tatsächlich höhere Effizienz (1.3 cd/A @ 100 cd/m² vs. 0.4 cd/A @ 100 cd/m²) und längere Lebensdauer (50 h vs. < 1 min.) zu zeigen. Jedoch können diese hier gezeigten Daten nicht als signifikant gewertet werden, da zum Zeitpunkt der Erfindung bereits weitaus bessere Polymere, sowohl in Bezug auf die Effizienz, als auch in Bezug auf die Lebensdauer bekannt waren: S. J. M. O'Connor et al, (Proceedings of SPIE 2001, 4105, 9-17) geben beispielsweise für ein blaues Copolymer eine Effizienz von 1.43 cd/A bei 100 cd/m² und eine Lebensdauer von 1600 h bei 100 cd/m² an. Ein Vorteil durch die Einführung blockartiger Strukturen ist also nicht ersichtlich.

Die Eigenschaften der bekannten Polymere in Elektrolumineszenzvorrichtungen haben sich also, wie beschrieben, in den letzten Jahren deutlich weiter entwickelt. Wie aus der Beschreibung des Stands der Technik jedoch auch ersichtlich ist, besteht weiterhin ein großer Weiterentwicklungsbedarf auf dem Gebiet der lichtemittierenden Polymere, da insbesondere die operative Lebensdauer, v. a. für blau emittierende Polymere, die Effizienz und die Betriebsspannung noch nicht den Voraussetzungen genügen, um die Polymere in hochwertige Vollfarbdisplays einzubauen.

Es wurde gefunden, dass bestimmte konjugierte Polymere, in denen geordnete Blöcke mit Polymerabschnitten verknüpft sind, die nicht blockartig aufgebaut sind, deutliche Verbesserungen, gerade auf den o. g. Gebieten, d. h. der operativen Lebensdauer, der Effizienz und der Betriebsspannung, zeigen.

Solche Polamere sind konjugierte Copolymere, die mindestens eine blockartige Struktur enthalten, die mindestens eine der folgenden Eigenschaften a - e aufweist:
a) Ladungstransportblock (entweder für Lochtransport oder Elektronentransport), oder
b) Ladungsinjektionsblock (entweder für die Injektion positiver oder negativer Ladungen), oder
c) emittierender Block, oder
d) Block, der den Übergang von Singulett- zu Triplett-Excitonen erleichtert, oder
e) Polymergrundgerüstblock,
dadurch gekennzeichnet, dass diese blockartigen Strukturen durch statistische oder teilstatistische Polymerabschnitte verknüpft sind.

Auch wenn dies aus der obigen Beschreibung hervorgeht, sei hier nochmals explizit darauf verwiesen, dass die Copolymere auch mehrere verschiedene der oben und a) bis e) aufgeführten blockartigen Strukturen enthalten kann.

Bevorzugt sind die statistischen bzw. teilstatistischen Polymerabschnitte aus mindestens vier unterschiedlichen Monomeren aufgebaut.

Unter einem Block soll hier allgemein ein Polymerabschnitt verstanden werden, der eine definierte Monomersequenz aufweist. Dabei kann dieser Block entweder aus alternierenden Strukturen, im einfachsten Fall also A-B-A-B bei nur zwei unterschiedlichen Monomeren, aufgebaut sein, oder es kann sich um einen Homoblock handeln, der also nur aus einer Monomersorte besteht. Unter einem Block soll hier also kein Polymerabschnitt verstanden werden, der statistische oder teilstatistische Monomersequenz aufweist.

Bevorzugt weisen die Blöcke alternierende Sequenzen der Wiederholeinheiten auf. Ebenfalls bevorzugt weisen die Blöcke Homosequenzen auf.

Unter einem statistischen Polymerabschnitt soll ein Polymerabschnitt verstanden werden, in dem die Sequenz aller Bausteine durch die bei der Polymerisation vorhandenen statistischen Gesetzmäßigkeiten gegeben ist. Unter einem teilstatistischen Polymerabschnitt soll ein Polymerabschitt verstanden werden, in dem die Anordnung einer der Wiederholeinheiten definiert ist, während die anderen Wiederholeinheiten statistisch angeordnet sind. Solche Abschnitte werden beispielsweise durch Reaktion eines Monomeren A mit zwei Monomeren B und B' erhalten, wenn sowohl B als auch B' nur mit A, nicht aber mit B oder B' reagieren kann.

Bevorzugt handelt es sich bei mindestens einem dieser Blöcke um einen Block, der den Lochtransport, den Elektronentransport, den Übergang von so genannten Singulett-Excitonen auf Triplett-Excitonen oder die Lichtemission ermöglicht. Dabei kann ein Block auch mehrere dieser Eigenschaften gleichzeitig erfüllen.

In einer besonders bevorzugten Ausführungsform enthält das Polymer Lochleiter-Homoblöcke.
In einer weiteren besonders bevorzugten Ausführungsform enthält das Polymer alternierende Lochleiter-Grundgerüst-Blöcke.
In einer weiteren besonders bevorzugten Ausführungsform enthält das Polymer Emitter-Homoblöcke.
In einer weiteren besonders bevorzugten Ausführungsform enthält das Polymer alternierende Emitter-Grundgerüst-Blöcke.
In einer weiteren besonders bevorzugten Ausführungsform enthält das Polymer mehrere Blöcke, die mehrere verschiedene blockartige Strukturen, zum Beispiel alternierende Lochleiter-Grundgerüst-Blöcke und alternierende Emitter-Grundgerüst-Blöcke, enthalten, die durch statistische oder teilstatistische Sequenzen oder einzelne Monomere verknüpft sind.
In einer weiteren besonders bevorzugten Ausführungsform enthält das Polymer mehrere verschiedene blockartige Strukturen, welche durch einen schrittweisen Aufbau direkt miteinander verknüft sind.

Der Anteil der Monomere, die im Polymer in Blöcken vorliegen, beträgt mindestens 1 mol%, bevorzugt mindestens 5 mol%, besonders bevorzugt mindestens 10 mol%.

Ein solcher Anteil hat sich insbesondere bei der Verwendung der Polymere als Elektrolumineszenzmaterialien als günstig erwiesen. Für andere Anwendungen kann jedoch auch ein deutlich höherer Anteil an Blöcken bevorzugt sein, beispielsweise ein Anteil von Ladungstransport-Blöcken von 50 mol% und mehr für die Verwendung des Polymers in organischen Feldeffekttransistoren (O-FETs).

Weiterhin werden besonders gute Ergebnisse erhalten, wenn die Blöcke ein Molekulargewicht M_{w} von 10³ - 3.10⁵ g/mol, bevorzugt von 3.10³ bis 10⁵ g/mol, besonders bevorzugt von 5.10³ bis 8-10⁴ g/mol aufweisen.

Der Anteil der Monomere, die im Polymer in statistischen oder teilstatistischen Abschnitten vorliegt, beträgt mindestens 1 mol%, bevorzugt mindestens 5 mol%, besonders bevorzugt mindestens 10 mol%, insbesondere mindestens 30 mol%.

Weiterhin enthalten die statistischen oder teilstatistischen Polymerabschnitte im Durchschnitt mindestens 2 Wiederholeinheiten, bevorzugt mindestens 5 Wiederholeinheiten, besonders bevorzugt mindestens 10 Wiederholeinheiten.

Ein konjugiertes Polymer ist dabei ein Polymer, das in der Hauptkette hauptsächlich sp²-hybridisierte Kohlenstoffatome, die auch durch entsprechende Heteroatome ersetzt sein können, enthält. Dies bedeutet im einfachsten Fall abwechselndes Vorliegen von Doppel- (oder auch Dreifach-) und Einfachbindungen in der Hauptkette. Hauptsächlich meint, dass natürlich auftretende Defekte, die zu Konjugationsunterbrechungen führen, den Begriff "konjugiertes Polymer" nicht entwerten. Im Sinne dieser Erfindung wird ebenfalls als konjugiert bezeichnet, wenn sich in der Hauptkette Arylamineinheiten und/oder bestimmte Heterocyclen (d. h. Konjugation über N-, O- oder S-Atome) und/oder metallorganische Komplexe (d. h. Konjugation über das Metallatom) befinden. Hingegen würden Einheiten wie beispielsweise einfache (Thio)Etherbrücken, Alkylenketten, Ester-, Amid- oder Imidverknüpfungen eindeutig als nicht konjugierte Segmente definiert.

Die Copolymere können verschiedene Strukturelemente enthalten. Dies sind u. a. solche, wie sie in den o. g. Patentanmeldungen bereits offenbart sind. Hier sei vor allem auch auf die relativ umfangreiche Auflistung in der oben schon erwähnten Anmeldeschrift WO 02/077060 verwiesen. Diese weiteren Struktureinheiten können beispielsweise aus den im Folgenden beschriebenen Klassen stammen:
1. Struktureinheiten, die das Polymergrundgerüst bilden, bzw. blau emittierende Einheiten:
   - Hier sind zunächst Polyphenylene und Einheiten, die davon abgeleitet Strukturen bilden, zu nennen. Dies sind beispielsweise (jeweils substituierte oder unsubstituierte) meta- oder para-Phenylene, 1,4-Naphthylene, 9,10-Anthracenylene, 2,7-Phenanthrenylene, 2,7-(9,10-Dihydro)phenanthrenylene, 1,6- bzw. 2,7- bzw. 4,9-Pyrene oder 2,7-Tetrahydropyrene. Auch entsprechende heterocyclische "Poly-Arylen"-bildende -Strukturen, wie beispielsweise Oxadiazolylen, 2,5-Thiophenylen, 2,5-Pyrrolylen, 2,5-Furanylen, 2,5-Pyridylen, 2,5-Pyrimidinylen, 3,6- bzw. 2,7-Carbazolylen oder 5,8-Chinolinylen kommen in Frage.
   - Des Weiteren sind komplexere Einheiten, wie die o. g. Fluorene, Spiro-9,9'-bifluorene, mehrfach überbrückte Einheiten (z. B. kurze Teilsegmente der o. g. L-PPP-Polymere), aber auch "doppelte" Fluoren-Einheiten (cis- oder trans-Indenofluorene) möglich. Auch diese können substituiert bzw. unsubstituiert sein.
   - Bevorzugte Einheiten sind Spiro-9,9'-bifluorene, Fluorene, Indenofluorene und Dihydrophenanthrene.
2. Struktureinheiten, die die Ladungsinjektions- bzw.
   Ladungstransporteigenschaften beeinflussen:
   Dies kann sich sowohl auf die Elektroneninjektions- oder - transporteigenschaften (wie beispielsweise Oxadiazol-Einheiten) als auch auf die Lochinjektions- oder -transporteigenschaften (wie beispielsweise Triarylamin-Einheiten) beziehen. Hier sei nochmals auf die umfangreiche Auflistung derartiger Struktureinheiten in der oben zitierten Anmeldeschrift WO 02/077060 verwiesen. Ebenso kommen für diesen Zweck Naphthylarylamine (WO 04/037887) oder Carbazol-Einheiten (DE 10304819.7) in Frage.
3. Struktureinheiten, die die Farbe der Emission verschieben, damit auch die Bandlücke des Polymers verändern und somit in der Regel auch die Ladungsinjektions- bzw. -transporteigenschaften verändern:
   - Hier sind beispielsweise heterocyclische Verbindungen, wie die in der o. g. Anmeldung WO 03/020790 unter den Formeln (XX) bis (XXXXVI) genannten Strukturen zu nennen.
   - Des Weiteren sind hier aber auch Arylenvinylen- oder Arylenacetylen-Strukturen, wie substituierte oder unsubstituierte Stilbenylene, Tolanylene,
   Bisstyrylarylene, Bis(arylacetylen)-arylene zu nennen.
   - Schließlich kann auch der Einbau von größeren aromatischen Einheiten, wie zum Beispiel Chrysenen, Naphthacenen, Pyrenen, Pentacenen, Perylenen oder Coronenen, den o. g. Effekt (Farbverschiebung) erzeugen.
4. Struktureinheiten, welche einen Transfer von so genannten Singulett-Excitonen zu Triplett-Excitonen ermöglichen und welche auch bei Raumtemperatur mit hoher Effizienz aus dem Triplettzustand Licht emittieren können:
   - Hierunter sind nun zunächst vor allem Verbindungen zu verstehen, welche Schweratome enthalten, d. h. Atome aus dem Periodensystem der Elemente mit einer Ordnungszahl von mehr als 36.
   - Besonders geeignet hierfür sind Verbindungen, welche d- und f -Übergangsmetalle enthalten, die die o. g. Bedingung erfüllen, Ganz besonders bevorzugt scheinen hier entsprechende Struktureinheiten, welche Elemente der Gruppe 8 bis 10 (d. h. Ru, Os, Rh, Ir, Pd, Pt) enthalten.
   - Als Struktureinheiten für die erfindungsgemäßen Polymeren kommen hier nun z. B. verschiedene Komplexe, welche beispielsweise in den Anmeldeschriften WO 02/068435, DE 10116962, EP 1239526 und WO 04/026886 beschrieben sind, in Frage.
   - Des Weiteren kann es hier sinnvoll sein, zusätzlich zu den oben genannten Verbindungen, die aus dem Triplett-Zustand Licht emittieren können, weitere Komponenten zu verwenden, die den Singulett-Triplett-Transfer erleichtern. Hierfür kommen beispielsweise Carbazole (DE 10304819.7) oder Carbazol-Dimere (DE 10328627.6) in Frage.

Eine Auswahl bevorzugter weiterer Einheiten der oben beschriebenen Polymere sind in der folgenden Übersicht aufgelistet. Dabei soll die Einfachbindung die Verknüpfung im Polymer symbolisieren. Sie deutet hier keine Methylgruppe an.

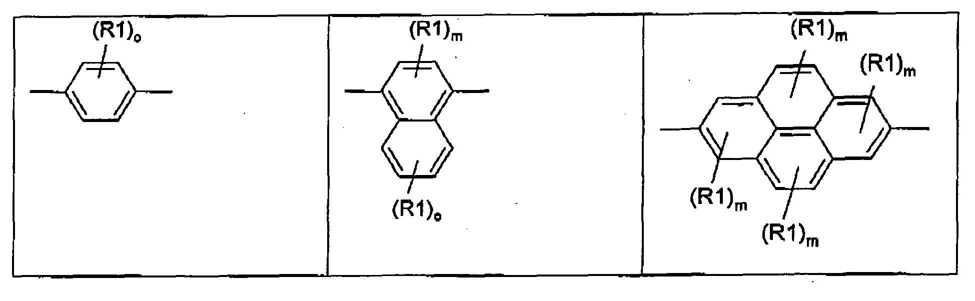

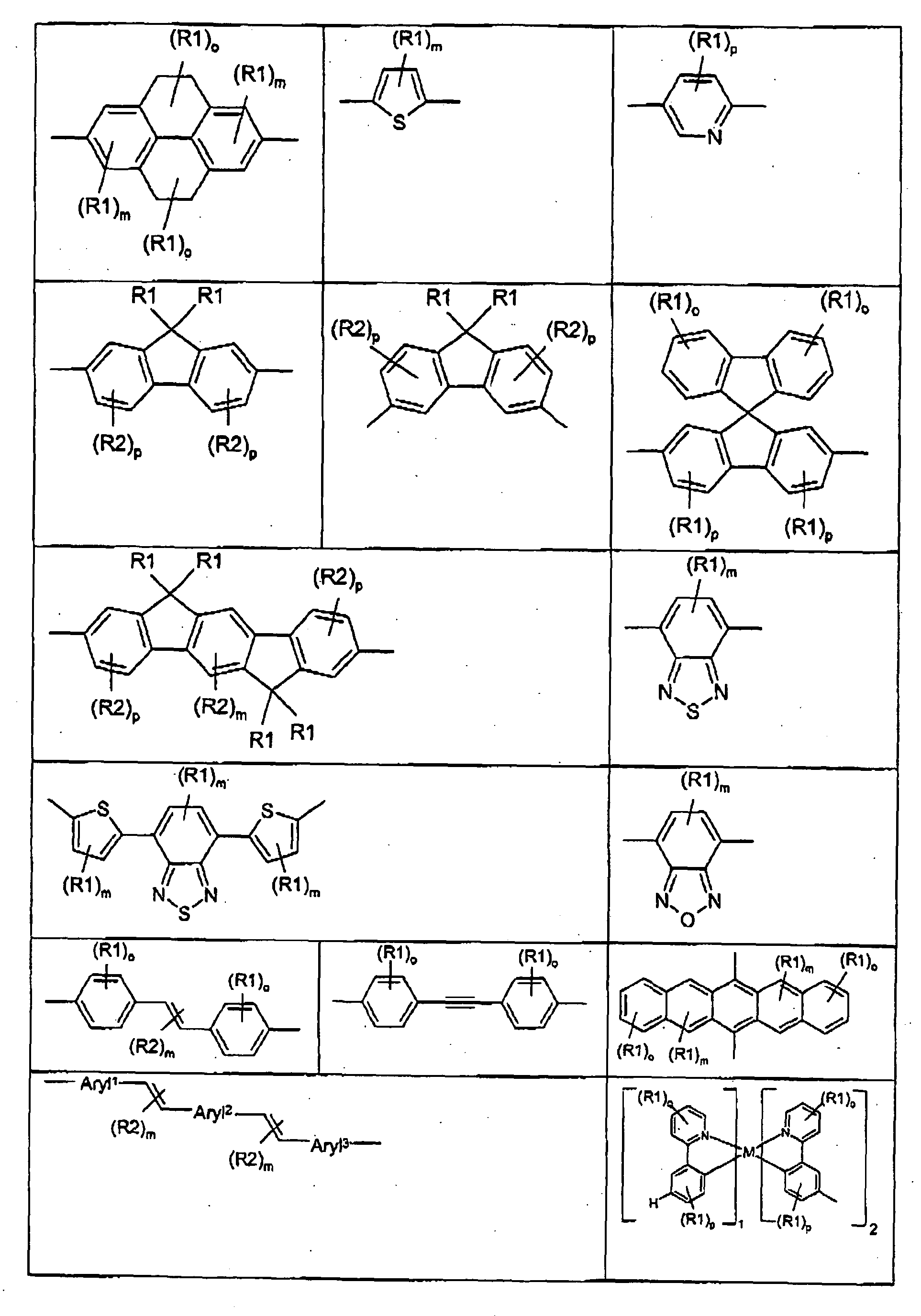

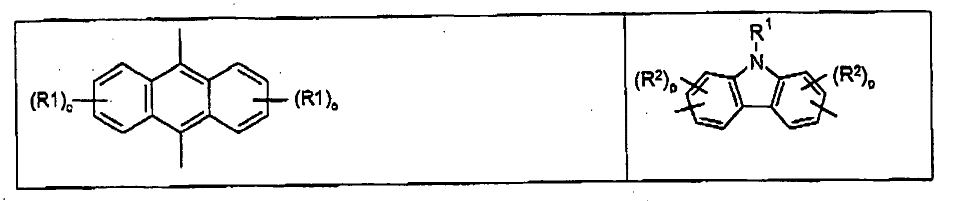

Dabei bedeuten die verwendeten Symbole R1, R2, Aryl¹, Aryl², Aryl³, M und Indizes m, o und p:
- Aryl¹, Aryl³: sind bei jedem Auftreten gleich oder verschieden einem aromatischen oder heteroaromatischen Ringsystem mit 2 bis 40 C-Atomen, welches substituiert oder auch unsubstituiert sein kann; die möglichen Substituenten R1 können dabei potentiell an jeder freien Position sitzen;
- Aryl²: ist bei jedem Auftreten gleich oder verschieden Aryl¹, Aryl³ oder einer substituierten bzw. unsubstituierten Stilbenylen- bzw. Tolanyleneinheit;
- R1: ist bei jedem Auftreten gleich oder verschieden eine geradkettige, verzweigte oder cyclische Alkyl- oder Alkoxykette mit 1 bis 22 Atomen, in der auch ein oder mehrere nicht benachbarte C-Atome durch NR2, O, S, CO-O, O-CO-O ersetzt sein können, wobei auch ein oder mehrere H-Atome durch Fluor ersetzt sein können, eine Aryl- oder Aryloxygruppe mit 5 bis 40 C-Atomen, bei der auch ein oder mehrere Atome durch O, S oder N ersetzt sein können, welche auch durch einen oder mehrere nicht-aromatische Reste R1 substituiert sein können, oder CI, F, CN, N(R2)₂, B(R2)₂, wobei auch zwei oder mehrere Reste R1 miteinander ein Ringsystem bilden können;
- R2: ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch O, S, CO-O, O-CO-O ersetzt sein können, wobei auch ein oder mehrere H-Atome durch Fluor ersetzt sein können, eine Arylgruppe mit 5 bis 40 C-Atomen, bei der auch ein oder mehrere Atome durch O, S oder N ersetzt sein können, welche auch durch ein oder mehrere nicht- aromatische Reste R1 substituiert sein können.
- m: sind gleich oder verschieden bei jedem Auftreten 0, 1 oder 2;
- o: ist bei jedem Auftreten gleich oder verschieden 0, 1, 2, 3 oder 4;
- p: ist bei jedem Auftreten gleich oder verschieden 0, 1, 2 oder 3;
- M: ist bei jedem Auftreten gleich oder verschieden Rh oder Ir,

Die Polymere weisen in der Regel 10 bis 10000, bevorzugt 50 bis 5000, besonders bevorzugt 50 bis 2000 Wiederholeinheiten auf.

Die nötige Löslichkeit wird v. a. durch die Substituenten R1 erreicht. In der Regel ist es deshalb nötig, dass im Durchschnitt pro Wiederholeinheit mindestens 2 nicht-aromatische C-Atome in den Substituenten vorhanden sind. Bevorzugt sind mindestens 4, besonders bevorzugt mindestens 8 C-Atome. Einzelne dieser C-Atome können auch durch O oder S ersetzt sein. Dies schließt nicht aus, dass ein gewisser Anteil von Wiederholeinheiten keine weiteren nicht-aromatischen Substituenten trägt.
Um die Morphologie des Films nicht zu verschlechtern, ist es bevorzugt, keine langkettigen Substituenten mit mehr als 12 C-Atomen in einer linearen Kette zu haben, bevorzugt keine mit mehr als 8 C-Atomen, besonders bevorzugt keine mit mehr als 6 C-Atomen.
Nicht-aromatische C-Atome sind, wie in der Beschreibung für R1, in entsprechenden geradkettigen, verzweigten oder cyclischen Alkyl- oder Alkoxyketten enthalten.

Die Copolymere enthalten nun bevorzugt mindestens eine Sorte Blöcke mit alternierender Monomersequenz oder Homo-Sequenz, wobei es sich dabei um Blöcke handeln kann, die die Lochinjektion bzw. den Lochtransport, die Elektroneninjektion bzw. den Elektronentransport, den Übergang von so genannten Singulett-Excitonen auf Triplett-Excitonen oder die Lichtemission beeinflussen. Dabei kann ein Block auch mehrere Eigenschaften gleichzeitig erfüllen. Diese Blöcke definierter Sequenz sind durch Polymerabschnitte statistischer oder teilstatistischer Sequenz verknüpft. Durch das Verwenden sowohl definierter Blöcke wie auch statistischer Polymerabschnitte in demselben Copolymer können Eigenschaften wie Löslichkeit, Festphasenmorphologie, Ladungstransporteigenschaften, etc. eingestellt werden und damit die Emissionseigenschaften des Polymers deutlich verbessert werden. Dies ist insbesondere der Fall, wenn für die statistischen Polymerabschnitte vier und mehr unterschiedliche Monomere verwendet werden.
Besonders bevorzugte Copolymere enthalten mindestens eine Sorte eines Ladungstransport-Blocks, der entweder aus alternierenden Einheiten eines Polymer-Grundgerüsts mit einer Ladungstransporteinheit oder nur aus Ladungstransporteinheiten aufgebaut ist, wobei die Blöcke über statistische oder teilstatistische Abschnitte miteinander verknüpft sind. Das bevorzugte Molekulargewicht M_{w} der Blöcke liegt dabei im Bereich von 5.10³- 8.10⁴.

Die oben beschriebenen Copolymere werden in der Regel durch Polymerisation von einem oder mehreren Monomeren hergestellt. Entsprechende Polymerisationsreaktionen, die sich hierfür eignen, gibt es prinzipiell relativ viele verschiedene; es haben sich jedoch die im Folgenden aufgeführten Polykondensationsreaktionen besonders bewährt. Grundsätzlich ergeben die Reaktionstypen (A) bis (C) C-C-Verknüpfungen, Reaktionstyp (D) ergibt C-N-Verknüpfungen:
(A) Polymerisation gemäß SUZUKI
(B) Polymerisation gemäß YAMAMOTO
(C) Polymerisation gemäß STILLE
(D) Polymerisation gemäß HARTWIG-BUCHWALD

Diese Methoden sind beispielsweise detailliert beschrieben in WO 03/048225 und WO 04/022626 und den darin zitierten Literaturstellen.

Die eigentliche Polymerisation (Polykondensation) (vgl. auch die Angaben bei den Beispielen) verläuft in zwei (oder mehr) Schritten. Zunächst wird in der Regel der Teil der Monomere, die den Block bilden sollen, in einem geeigneten Konzentrationsbereich in Lösung mit den entsprechenden Katalysatoren und Hilfssystemen zur Reaktion gebracht. Wird nur eine Sorte Wiederholeinheiten verwendet, werden dadurch Homoblöcke gebildet. Für eine alternierende Sequenz im Block kann man sich beispielsweise die charakteristische Eigenschaft der Polymerisationsverfahren (A), (C) und (D) zu Nutze machen, dass die Monomere nicht mit sich selbst, sondern nur mit Monomeren mit anderen funktionellen Gruppen reagieren können. Die Größe der Blöcke kann dabei beispielsweise durch Abweichung von der 1:1 Stöchiometrie der unterschiedlichen Monomere kontrolliert werden, aber auch durch die Reaktionszeit vor Zugabe der weiteren Monomere. Hat der Block die gewünschte Größe erreicht, werden die restlichen Monomere, gegebenenfalls zusammen mit weiterem Lösungsmittel, Katalysator und weiteren Hilfssystemen zugegeben, und die Polymerisation wird fortgeführt. Dabei kann es vorteilhaft sein, durch geringe Abweichungen von der idealen Stöchiometrie, bzw. durch das Vorhandensein geringer Mengen mono-funktioneller Verbindungen, eine Molekulargewichtsbegrenzung durchzuführen. Die Reaktion wird i. d. R. bis zum gewünschten Molekulargewicht durchgeführt (dabei kann beispielsweise Prozesskontrolle über Viskositätsmessung, etc. erfolgen). Man kann aber auch noch weitere, vom ersten unterschiedliche Blöcke aufbauen, die dann über die statistischen oder teilstatistischen Abschnitte verknüpft werden. Ebenso ist es möglich, die Polymerisation mit dem statistischen oder teilstatistischen Abschnitt zu beginnen und die Blöcke erst im Anschluss daran, wie oben beschrieben, aufzubauen. Des Weiteren ist ebenfalls möglich, sowohl die Blöcke als auch die statistischen oder teilstatistischen Abschnitte getrennt vorzupolymerisieren und anschließend das Polymer durch das Knüpfen weniger neuer Bindungen zwischen den Blöcken und den statistischen oder teilstatistischen Abschnitten weiter zu polymerisieren. Danach wird die Reaktion abgebrochen. Dies kann auf verschiedene Weise erfolgen. Um reaktive Endgruppen zu vermeiden, hat es sich bewährt, ein sogenanntes "Endcapping" durchzuführen, d. h. nach Erreichen des gewünschten Molekulargewichts monofunktionelle Verbindungen zuzugeben. Bei den Reaktionstypen A, C und D kann dies auch doppelt erfolgen, d. h. man gibt zunächst eine/mehrere monofunktionelle Verbindung(en) des einen Typs (z. B. Monohalogenid) und anschließend des anderen Typs (z. B. Monoboronsäurederivat) zu.

Danach müssen die synthetisierten Copolymere zunächst vom Reaktionsmedium abgetrennt werden. Die Isolierung und Aufreinigung der so erhaltenen Polymere ist bereits detailliert beispielsweise in WO 04/037887 beschrieben und wird an dieser Stelle nicht nochmals ausgeführt.

Um die beschriebenen Polymere beispielsweise durch die beschriebenen Verfahren herstellen zu können, werden die entsprechenden Monomere eingesetzt, Die Synthese, welche zu Strukturen führen, wie sie oben beschrieben wurden, ist in den bereits oben genannten Anmeldeschriften und Patenten ausführlich beschrieben. Einen guten Überblick hierzu gibt dabei die Anmeldeschrift WO 02/077060. Für Homo-Blöcke aus Triarylamin-Einheiten benötigt man für das Polymerisationsverfahren (A) außer den entsprechenden Dihalogeniden auch die entsprechenden Boronsäurederivate. Auch für die vollstatistischen Polymere werden von allen Monomeren sowohl die Halogenide wie auch die entsprechenden Boronsäurederivate benötigt.
- Boronsäurederivate von Triarylamin-Einheiten können beispielsweise durch Umsetzung der entsprechenden Dihalogenid-Verbindung mit einer Alkyllithium-Verbindung, gefolgt von Reaktion mit Triisopropylborat erhalten werden. Ebenso ist die Umsetzung zum Grignard-Reagens, gefolgt von Reaktion mit Triisopropylborat, möglich.
- Eine andere Synthesemöglichkeit ist die Umsetzung der entsprechenden Dihalogenide mit Diboranen oder Boranen unter Palladium-Katalyse. Dies stellt eine gute Alternative zu obiger Synthese dar, wenn es sich um Substanzen handelt, die empfindlich gegenüber Basen sind und sich nicht oder nicht selektiv lithiieren oder zum Grignard-Reagens umsetzen lassen.
- Eine weitere Möglichkeit, die entsprechenden Boronsäurederivate zu erhalten, geht aus von primären oder sekundären Arylaminverbindungen. Diese können dann in einer HARTWIG-BUCHWALD-Kupplung unter dem Fachmann geläufigen Reaktionsbedingungen mit einer Aryl-monohalogenid-monoboronsäureester-Verbindung umgesetzt werden.
- Die so erhaltenen Boronsäuren oder Boronsäurederivate können gegebenenfalls durch Veresterung bzw. Umesterung weiter zu anderen Boronsäureestern umgesetzt werden. Dies kann für die Anwendung Vorteile bringen, da die Boronsäureester durch unterschiedliche Löslichkeitseigenschaften leichter aufgereinigt werden können. Außerdem ist von Interesse, dass unterschiedliche Boronsäureester unterschiedliche Stabilitäten und Reaktivitäten aufweisen.

Die direkte Umsetzung von primären oder sekundären Arylaminen mit Arylmonohalogenid-monoboronsäureester-Verbindungen, bei der die Halogenidfunktionalität unter Beibehaltung der Boronsäureesterfunktionalität reagiert, ist unerwartet und neu.
Gegenstand der Erfindung ist somit ein Verfahren gemäß Formel (I) zur Herstellung von Aryl- oder (Heteroaryl)amin-Boronsäurederivaten durch HARTWIG-BUCHWALD-Kupplung eines primären oder sekundären Amins in Gegenwart einer Palladiumverbindung, mindestens eines Phosphinliganden und einer Base, dadurch gekennzeichnet, dass die Reaktion mit einer Aryl- oder Heteroaryl-monohalogenidmonoboronsäureester-Verbindung bzw. mit einer Aryl- oder Heteroarylmonosulfonat-monoboronsäureester-Verbindung durchgeführt wird: 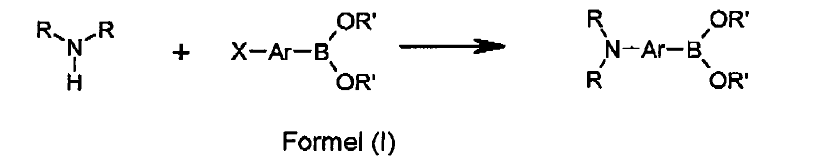 wobei für die verwendeten Symbole gilt:
- R: ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch N-R", O, S, CO-O, O-CO-O ersetzt sein können, wobei auch ein oder mehrere H-Atome durch Fluor ersetzt sein können, eine Aryl- oder Heteroarylgruppe mit 5 bis 40 C-Atomen, bei der auch ein oder mehrere C-Atome durch O, S oder N ersetzt sein können und welche auch durch einen oder mehrere nicht-aromatische Reste R substituiert sein kann, wobei auch zwei oder mehrere der Reste R miteinander ein Ringsystem bilden können, mit der Maßgabe, dass mindestens einer der Reste R an der Ausgangsverbindung ungleich H ist;
- R': ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch O, S, CO-O, O-CO-O ersetzt sein können, wobei auch ein oder mehrere H-Atome durch Fluor ersetzt sein können, eine Aryl- oder Heteroarylgruppe mit 5 bis 40 C-Atomen, bei der auch ein oder mehrere C-Atome durch O, S oder N ersetzt sein können und welche auch durch einen oder mehrere nicht-aromatische Reste R substituiert sein kann, wobei auch ein oder mehrere Reste R' miteinander ein Ringsystem bilden können;
- X: ist bei jedem Auftreten gleich oder verschieden CI, Br, I oder O-SO₂R', mit der Vorgabe, dass R' hier ungleich H ist;
- Ar: ist bei jedem Auftreten gleich oder verschieden eine Arylen- oder Heteroarylengruppe mit 5 bis 40 C-Atomen, bei der auch ein oder mehrere Atome durch O, S oder N ersetzt sein können, welche auch durch einen oder mehrere Reste R' substituiert sein kann.

Diese Synthese gemäß Formel (I) lässt sich beispielsweise einsetzen für die Synthese von Boronsäureester-substituiertem Tetraphenylbenzidin, wie in Formel (II) dargestellt:

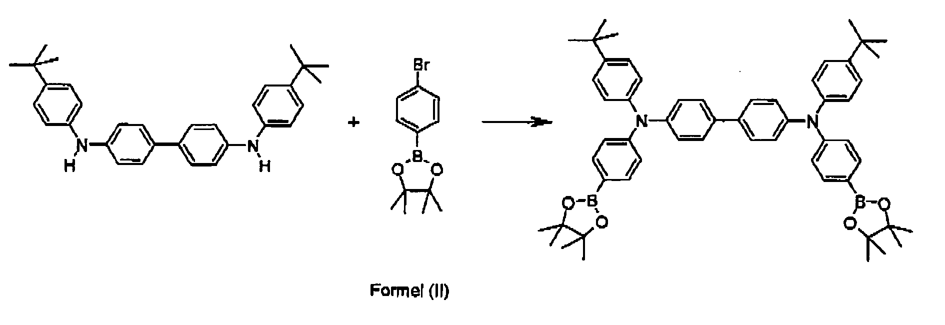

Die oben beschriebenen Polymere weisen nun u. a. folgende überraschende Vorteile auf:
- Die operative Lebensdauer bei der Verwendung in PLEDs ist bei vergleichbaren Polymeren deutlich erhöht (vgl. Angaben in Tabelle 1). Dies ist vor allem der Fall, wenn Ladungstransport-Homoblöcke verwendet werden. Dies bringt für die Anwendung deutliche Vorteile, da somit das Ziel, langlebige Vollfarbdisplays zu erzeugen, näher gerückt ist.
- Die Effizienz kann bei vergleichbaren Polymeren deutlich erhöht werden, wenn diese sowohl geordnete Blöcke wie auch statistische oder teilstatistische Abschnitte mit mindestens vier unterschiedlichen Monomeren enthalten. Dieser Effekt ist ebenfalls bei Ladungstransport-Homoblöcken besonders ausgeprägt.

Dies ist den Angaben in Tabelle 1 zu entnehmen.
- Die Betriebsspannung bei der Verwendung in PLEDs kann deutlich gesenkt werden, wenn das Polymer geeignete Ladungstransport-Blöcke enthält. Hier sind die Ergebnisse besonders gut, wenn im Block die LadungstransportEinheiten mit Polymergrundgerüstbausteinen alternieren.
- Entsprechende Copolymere können so aufgebaut werden, dass diese alle

Grundfarben (Rot, Grün, Blau) emittieren können.
- Die Löslichkeit in organischen Lösemitteln ist in der Regel gut, d. h. in Lösemitteln wie Toluol, Xylol, Anisol, Methylanisol, Methylnaphthalin sind die Polymere in Mengen im Bereich von 1 bis ca. 30 g/L (je nach Art des Blocks und Molekulargewicht des Polymers) löslich.

Die letzten beiden Punkte bringen zwar keine Verbesserung gegenüber bekannten Materialien, jedoch ist es essentiell, dass diese Eigenschaften auch bei den oben beschriebenen Polymeren erhalten bleiben.

Die oben beschriebenen Copolymere können in PLEDs verwendet werden. Wie PLEDs hergestellt werden können, wird als allgemeines Verfahren ausführlich in WO 041037887 beschrieben, das entsprechend für den Einzelfall anzupassen ist. Wie oben beschrieben, eignen sich die Copolymere ganz besonders als Elektrolumineszenzmaterialien in den derart hergestellten PLEDs oder Displays.

Als Elektrolumineszenzmaterialien gelten dabei Materialien, die als aktive Schicht in einer PLED Verwendung finden können. Aktive Schicht bedeutet, dass die Schicht befähigt ist, bei Anlegen eines elektrischen Feldes Licht abzustrahlen (lichtemittierende Schicht), und/oder dass sie die Injektion und/oder den Transport der positiven und/oder negativen Ladungen verbessert (Ladungsinjektions- oder Ladungstransportschicht).

Im vorliegenden Anmeldetext und auch in den im Weiteren folgenden Beispielen wird hauptsächlich auf die Verwendung der oben beschriebenen Copolymere in Bezug auf PLEDs und den entsprechenden Displays abgezielt. Trotz dieser Beschränkung der Beschreibung ist es für den Fachmann möglich, diese Polymere auch für weitere Verwendungen in anderen elektronischen Devices (Vorrichtungen) zu benutzen, z. B. O-ICs, OFETs, OTFTs, O-SCs, O-Laser oder auch nicht-lineare Optik, um nur einige Anwendungen zu nennen. Gerade für O-ICs und OFETs können entsprechende

Copolymere, welche einen relativ hohen Anteil an Ladungstransport-Homoblöcken oder alternierenden Ladungstransport-Blöcken aufweisen, Verwendung finden.

Die Erfindung wird durch die nachfolgenden Beispiele näher erläutert.

### Beispiele

### Teil A: Synthese der Monomere

### A1: Synthese von Boronester-Monomeren (benötigt für die Synthese von Blöcken oder statistischen Polymeren)

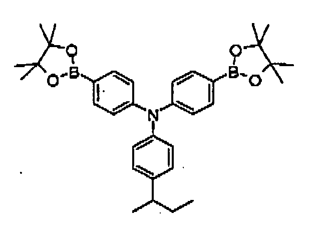

### A1.1 Synthese N,N-Bis-(4-boronsäurepinakolester)phenyl-N-(4-tert-butylphenyl)amin (BOR1)

In einem ausgeheizten 5L Vierhalskolben mit mechanischem Rührer, Stickstoffanschluss, Tropftrichter und Tieftemperaturthermometer wurden 150 g (327 mmol) Monomer M11 (substituiert mit einer sec-Butylgruppe) in 2.5 L trockenem THF gelöst und auf -78 °C gekühlt. 390 mL (975 mmol) Butyllithium (2.5 molare Lösung in Hexan) wurden so zu der Reaktionsmischung getropft, dass die Innentemperatur-70 °C nicht überstieg. Nach Beendigung der Zugabe wurde weitere 45 Minuten bei -78 °C gerührt. Dann wurden 230 mL (991 mmol) Triisopropylborat tropfenweise so zugegeben, dass die Innentemperatur -70 °C nicht überstieg. Es wurde noch weitere 4 h bei -78 °C gerührt, dann wurden 500 mL HCI (2 molare Lösung in Diethylether) bei -70 °C zugegeben, und man ließ die Mischung auf Raumtemperatur kommen. Das Produkt wurde im Vakuum eingeengt. Der Rückstand wurde in 1 L Toluol aufgenommen und das ausgefallene LiBr abfiltriert. 112 g (950 mmol) Pinakol und 1 g para-Toluolsulfonsäure wurden zugegeben, und die Reaktionsmischung wurde 2 h am Wasserabscheider unter Rückfluss erhitzt. Nach Abkühlen auf Raumtemperatur wurden 3 g Kaliumcarbonat zugegeben, die Mischung wurde filtriert und im Vakuum eingeengt. Das Produkt wurde mit 200 mL Ethylacetat 1 h ausgerührt, filtriert und über Nacht bei 40 °C unter Vakuum getrocknet. Das reine Produkt wurde durch wiederholte Umkristallisation aus Ethylacetat gewonnen. Es wurden 45.2 g (25 % d. Th.) des Produktes in einer Reinheit von 100 % (nach HPLC und GC/MS) erhalten.
¹H-NMR (500 MHz, CDCl₃): 0.84 (t, J = 7.4 Hz, 3H, CH₃), 1.23 (d, J = 7 Hz, 3H, CH₃), 1.33 (s, 24H, Pinakol) 1.57 (m, 2H, CH₂), 2.57 (m, 1H, CH), 7.04 (m, 8H, Phenylen), 7.66 (m, 4H, Phenylen).

### A1.2 Synthese von Monomer BOR2

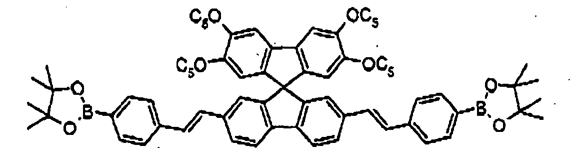

20.46 g (20 mmol) Monomer **M19** wurden in 520 mL Dioxan vorgelegt. Es wurden 20 mL (144 mmol) Triethylamin, 9.9 mL (68 mmol) Pinakolboran und anschließend 1 g (1.36 mmol) [1,1-Bis(diphenylphosphino)ferrocen]palladium(II)-chlorid zugegeben und der Ansatz wurde unter Argon 72 h auf 80 °C erhitzt. Das Dioxan wurde unter Vakuum entfernt. Der Rückstand wurde in 500 mL Ethylacetat und 500 mL Wasser aufgenommen und filtriert. Die Phasen wurden getrennt, und die wässrige Phase wurde mit 3 x 150 mL Ethylacetat extrahiert. Die vereinigten organischen Phasen wurden über MgSO₄ getrocknet und das Lösungsmittel wurde im Vakuum entfernt. Das Rohprodukt wurde mit Hexan ausgerührt, filtriert und getrocknet. Weitere Reinigung erfolgte durch wiederholte Umkristallisation aus Dioxan. Es wurden 9.37 g (42 % d. Th.) Produkt in einer Reinheit von 99.7 % (nach HPLC) erhalten.
¹H-NMR (CDCl₃, 500 MHz): 0.86 (t, ³J_{HH} = 7.5 Hz, 6H, CH₃), 0.93 (d, ³J_{HH} = 9.7 Hz, 6H, CH₃), 0.99 (t, ³J_{HH} = 7.3 Hz, 6H, CH₃), 1.09 (d, ³J_{HH} = 6.7 Hz, 6H, CH₃), 1.18 (m, 2H, CH₂), 1.34 (m, 2H, CH₂), 1.36 (s, 24H, CH₃), 1.48 (m, 2H, CH), 1.64 (m, 2H, CH), 1.75 (m, 2H, CH₂), 1.95 (m, 2H, CH₂), 3.55 (m, 4H, CH₂), 3.95 (m, 4H, CH₂), 6.20 (s, 2H, Spiro), 6.88 (s, 2H, Spiro), 6.91 (2 d, ³J_{HH}=16,1 Hz, 4H, Olefin), 7.26 (m, 2H, Spiro), 7.72 (d, ³J_{HH} = 9.0 Hz, 4H, Phenylen), 7.49 (dd, ³J_{HH} = 8.0 Hz, ⁴J_{HH} = 1.4 Hz, 2H, Spiro), 7.55 (d, ³J_{HH}= 8.9 Hz, 4H, Phenylen), 7.78 (d, ³J_{HH} = 7.7 Hz, 2H, Spiro).

### A1.3 Synthese von N,N'-Bis-(4-boronsäurepinakolester)phenyl-N,N'-bis-(4-tert-butylphenyl)-biphenyl-4,4'-diamin (BOR3)

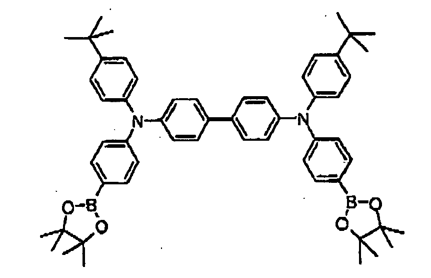

Eine entgaste Lösung von 8.75 g (19.5 mmol) N,N'-Bis-(4-tert-butylphenyl)-biphenyl-4,4'-diamin und 12.11g (42.8 mmol) 1-Brom-4-(pinakolboran)benzol in 500 mL Toluol wurde 1 h lang mit N₂ gesättigt. Dann wurde die Lösung mit 157.8 mg (0.78 mmol) P(^{t}Bu)₃ und 87.6 mg (0.39 mmol) Pd(OAc)₂ versetzt, anschließend wurden 4.84 g (50.4 mmol) NaO^{t}Bu im festen Zustand zugegeben. Die Reaktionsmischung wurde 4 h unter Rückfluss erhitzt. Nach Abkühlen auf Raumtemperatur wurden vorsichtig 153 mg NaCN und 10 mL Wasser zugesetzt. Die organische Phase wurde mit 4 x 50 mL H₂O gewaschen, über MgSO₄ getrocknet und die Lösungsmittel in Vakuum entfernt. Das reine Produkt erhielt man durch Umkristallisation aus Dioxan. Die Ausbeute betrug 6.6 g (40 % d. Th.), die Reinheit 99.8% (nach HPLC).
¹H-NMR (CDCl₃, 500 MHz): 1.32 (s, 18H), 1.33 (s, 24H), 7.05 (d, J = 8.7 Hz, 8H), 7.13 (d, J = 8.7 Hz, 4H), 7.27 (d, J = 8.4 Hz, 4H), 7.45 (d, J = 8.4 Hz, 4H), ), 7.66 (d, J = 8.7Hz, 4H).

### A2: Monomere für weitere Einheiten

Die Synthese der weiteren Monomere **M1** bis **M23** ist bereits in WO 02/077060 und der darin zitierten Literatur ausführlich beschrieben worden. Die Monomere sind zur besseren Übersicht im Folgenden nochmals dargestellt:

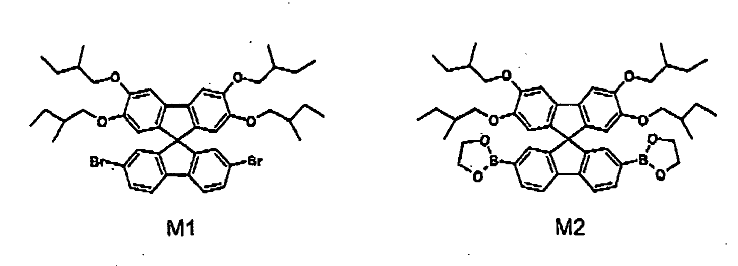

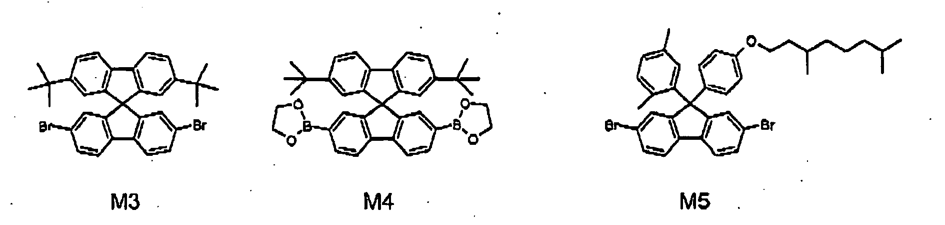

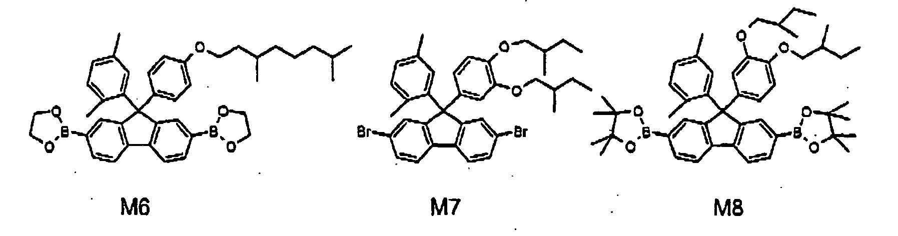

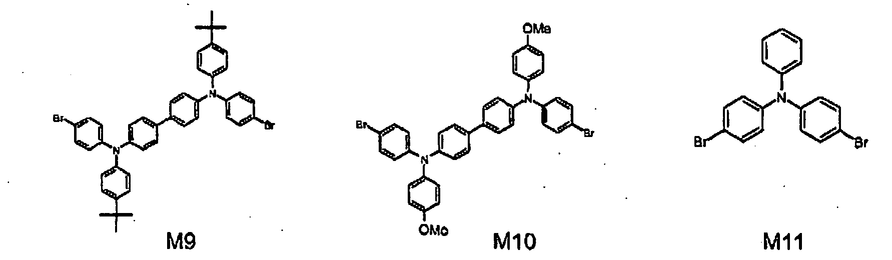

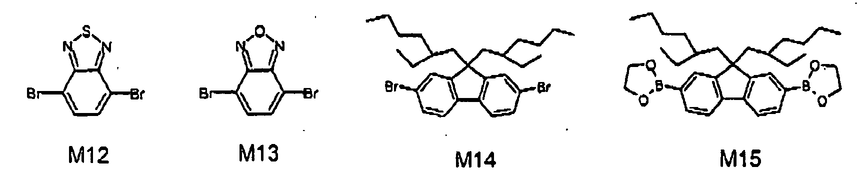

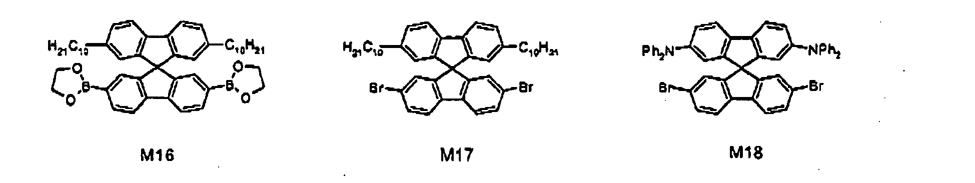

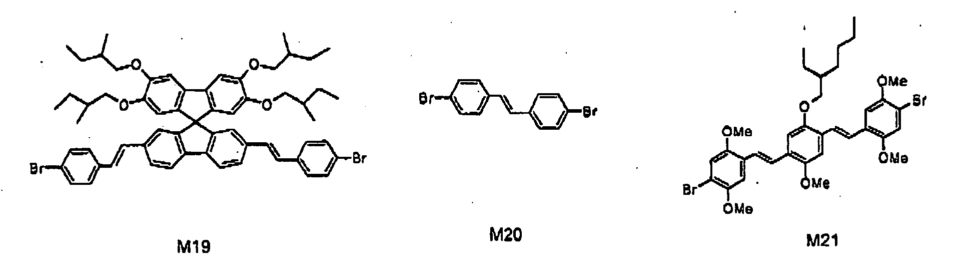

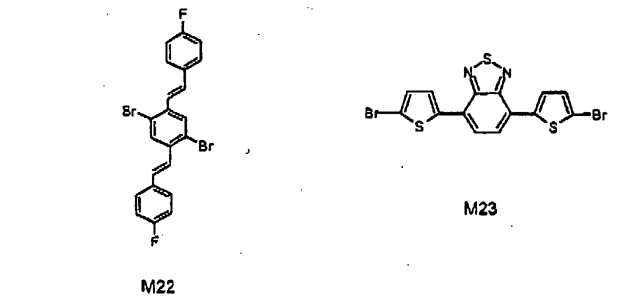

### Teil B: Herstellung der Polymere

### Synthese von Polymer P1:

### Polymer mit alternierendem Lochleiter-Grundgerüst-Block, verknüpft mit statistischen Emitter-Grundgerüst-Abschnitten

0.6069 g (0.8 mmol) Monomer **M9**, 0.5765 g (0.72 mmol) Monomer **M2** und 3.91 g Kaliumphosphat-Hydrat wurden gelöst in 25 mL Toluol, 25 mL Dioxan und 6.8 mL Wasser (alle Lösungsmittel sauerstofffrei). Die Reaktionslösung wurde 30 Minuten mit Argon entgast. Dann wurden 0.45 mg Pd(OAc)₂ und 3.65 mg P(o-tolyl)₃ als Katalysator zugegeben, und die Lösung wurde 4 h unter Rückfluss unter einer Argon-Atmosphäre erhitzt. Für den Block wurde ein Molekulargewicht von Mₙ = 13.7 kDa und M_{w} = 34.4 kDa bestimmt. Anschließend wurden 0.8118 g (1.2 mmol) Monomer M7, 0.9248 g (1.2 mmol) Monomer **M8**, 1.6333 g (2.04 mmol) Monomer **M2**, 0.9825 g (1.2 mmol) Monomer **M1** und 0.8185 g (0.8 mmol) Monomer **M19** zugegeben, und die Mischung wurde weitere 5 h unter Rückfluss erhitzt. Dann wurde das Endcapping durchgeführt, indem 0.1 mL Brombenzol und 50 mL Toluol zugegeben wurden, dann wurde 1 h unter Rückfluss erhitzt, 200 mg Benzolboronsäure und 40 mL Toluol zugegeben und 1 h unter Rückfluss erhitzt. Die Polymerlösung wurde mit 100 mL Toluol verdünnt und bei 60 °C mit 100 mL 0,01 %iger wässriger NaCN-Lösung 3 h ausgerührt. Dann wurden die Phasen getrennt und die organische Phase mit 4 x 100 mL H₂O gewaschen. Das Polymer wurde durch Eintropfen in das doppelte Volumen an Methanol ausgefällt und filtriert. Weitere Reinigung erfolgte durch Lösen in 500 mL THF bei 60 °C unter Argon, Filtration über Celit und erneute Fällung durch Zugabe des doppelten Volumens Methanol. Das Polymer wurde filtriert und unter Vakuum getrocknet. Es wurden 4.66 g (93 % d.Th.) Polymer isoliert, M_{w} = 993 kDa, Mₙ = 200 kDa, Polydispersität = 5.0.

### Synthese von Polymer P2:

### Polymer mit alternierendem Lochleiter-Grundgerüst-Block, verknüpft mit teilstatistischen Emitter-Grundgerüst-Abschnitten

Synthese analog zu **P1** mit 1.214 g (1.6 mmol) Monomer **M9,** 1.153 g (1.44 mmol) Monomer **M2** und 4.05 g Kaliumphosphat-Hydrat in 25 mL Dioxan, 25 mL Toluol und 7 mL Wasser für den Block und 1.4091 g (1.67 mmol) Monomer **M2**, 0.5415 g (0.8 mmol) Monomer **M7,** 0.6165 g (0.8 mmol) Monomer **M8,** 0.6550 g (0.8 mmol) Monomer **M1** und 0.819 g (0.8 mmol) Monomer **M19** und 10 mL Dioxan/Toluol (1:1) für den statistischen Abschnitt. Ausbeute: 4.55 g (90 % d. Th.). Mₙ = 91 kDa, M_{w} = 392 kDa, Polydispersität 4.3. Molekulargewicht des Blocks: Mₙ =10.2 kDa, M_{w} = 27.8 kDa.

### Synthese von Polymer P3:

### Polymer mit Lochleiter-Homoblock, verknüpft mit statistischen Emitter-Backbone-Abschnitten

Synthese analog zu P1 mit 0.2021 g (0.44 mmol) **M11** (substituiert in 4-Position des nicht bromierten Phenylrings mit einer *sec*-Butylgruppe), 0.1992 g (0.36 mmol) Monomer **BOR1** und 4.05 g Kaliumphosphat-Hydrat in 2.5 mL Dioxan, 2.5 mL Toluol und 20 mL Wasser für den Block und 1.624 g (2.4 mmol) Monomer **M7,** 0.295 g (0.36 mmol) Monomer **M1,** 2.914 g (3.64 mmol) Monomer **M2** und 0.818 g (0.8 mmol) Monomer **M19** in 22.5 mL Dioxan und 22.5 mL Toluol für die teilstatistischen Abschnitte, Ausbeute: 4.56 g (92 % d. Th.). Mₙ = 96 kDa; M_{w} = 361 kDa; Polydispersität = 3.7.

### Synthese von Polymer P4:

### Polymer mit Lochleiter-Homoblock, verknüpft mit statistischen Emitter-Backbone-Abschnitten

Synthese analog zu **P1** mit 0.1947 g (0.42 mmol) Monomer **M11** (substituiert in 4-Position des nicht bromierten Phenylrings mit einer *sec*-Butylgruppe), 0.2081 g (0.34 mmol) Monomer **BOR1** und 4.05 g Kaliumphosphat-Hydrat in 2.5 mL Dioxan, 2.5 mL Toluol und 20 mL Wasser für den Block und 1.6309 g (1.99 mmol) Monomer **M1**, 1.6077 g (2.01 mmol) Monomer **M2,** 0.8064 g (1.19 mmol) Monomer **M7,** 0.9310 g (1.21 mmol) Monomer **M8,** 0.4010 g (0.39 mmol) Monomer **M19** und 0.4558 g (0,41 mmol) Monomer **BOR2** in 22.5 mL Dioxan und 22.5 mL Toluol für die vollstatistischen Abschnitte. Ausbeute: 4.18 g Polymer (87 % d. Th.). Mₙ =78 kDa; M_{w} = 304 kDa; Polydispersität = 3.9.

### Synthese von Polymer P5:

### Polymer mit alternierendem Lochleiter-Grundgerüst-Block, verknüpft mit teilstatistischen Emitter-Grundgerüst-Abschnitten

Synthese analog zu **P1** mit 0.6069 g (0.8 mmol) Monomer **M9,** 0.6085 g (0.76 mmol) Monomer **M2** und 4.05 g Kaliumphosphat-Hydrat in 5 mL Toluol, 5 mL Dioxan und 20 mL Wasser für den Block und 1.1496 g (1.6 mmol) Monomer **M21,** 2.5749 g (3.21 mmol) Monomer **M2** und 1.0825 g (1.6 mmol) Monomer **M7** in 15 mL Dioxan und 15 mL Toluol für die teilstatistischen Abschnitte. Ausbeute: 4.62 g (96 % d. Th.) Polymer isoliert. M_{w} = 297 kDa, Mₙ = 72 kDa, Polydispersität = 4.1. Molekulargewicht des Blocks: Mₙ = 30.3 kDa, M_{w} = 83.6 kDa.

### Synthese von Polymer P6:

### Polymer mit Lochleiter-Homoblock, verknüpft mit teilstatistischen Emitter-Backbone-Abschnitten

Synthese analog zu **P1** mit 0.2021 g (0.44 mmol) **M11** (substituiert in 4-Position des nicht-bromierten Phenylrings mit einer *sec*-Butylgruppe), 0.1992 g (0.36 mmol) Monomer **BOR1** und 4.05 g Kaliumphosphat-Hydrat in 2.5 mL Dioxan, 2.5 mL Toluol und 20 mL Wasser für den Block und 1.082 g (1.6 mmol) Monomer **M7,** 0.295 g (0.36 mmol) Monomer **M1**, 2.914 g (3.64 mmol) Monomer **M2** und 1.149 g (1.6 mmol) Monomer **M21** in 17.5 mL Dioxan und 17.5 mL Toluol für den teilstatistischen Abschnitt. Ausbeute: 4.5 g Polymer (98 % d. Th.). Mₙ = 70 kDa; M_{w} = 296 kDa; Polydispersität = 4.2.

### Synthese von Polymer P7:

### Polymer mit alternierendem Lochleiter-Grundgerüst-Block, verknüpft mit teilstatistischen Emitter-Grundgerüst-Abschnitten

Synthese analog zu **P1** mit 0.6069 g (0.8 mmol) Monomer **M9,** 0.6085 g (0.76 mmol) Monomer **M2** und 4.05 g Kaliumphosphat-Hydrat in 2.5 mL Toluol, 7.5 mL Dioxan und 20 mL Wasser für den Block und 0.1833 g (0.4 mmol) Monomer **M23,** 0.8231 g (2.8 mmol) Monomer **M12** und 2.5941 g (3.24 mmol) Monomer **M2** in 22,5 mL Dioxan und 7.5 mL Toluol für die teilstatistischen Abschnitte. Ausbeute: 3.40 g (92 % d. Th.); M_{w} =149 kDa, Mₙ = 53 kDa, Polydispersität = 2.8. Molekulargewicht des Blocks: Mₙ = 30.0 kDa, M_{w} = 79.4 kDa.

Weitere Polymere wurden analog den Beschreibungen für **P1** bis **P7** dargestellt. Die chemischen Eigenschaften sind in Tabelle 1 zusammengefasst. Es wurden nach analoger Methode auch einige Vergleichspolymere (in der Tabelle als "**V**" abgekürzt) dargestellt, die keine Blöcke enthalten und die entweder teilstatistisch oder vollstatistisch aufgebaut sind. Auch diese sind in der Tabelle mit aufgeführt. Alle diese Polymere wurden auch für einen Einsatz in PLEDs untersucht. Wie PLEDs dargestellt werden können, ist bereits in WO 04/037887 und der darin zitierten Literatur ausführlich beschrieben.

Auch die wichtigsten Device-Eigenschaften (Farbe, Effizienz, Betriebsspannung und Lebensdauer) sind in der Tabelle mit aufgeführt.
Hier wird klar ersichtlich, dass die Verwendung von alternierenden Lochteiter-Grundgerüst-Blöcken zu einer deutlichen Reduzierung der Betriebsspannung führt, abhängig von der eingebauten Menge diese Blöcke. Weiterhin ist offensichtlich, dass beispielsweise die Verwendung von Lochleiter-Homoblöcken die Effizienz und die Lebensdauer der Polymere deutlich steigert. Dabei bleibt die Emissionsfarbe der Polymere überwiegend unverändert.

**Tabelle 1:**

| | Anteil der Monomere in der Polymetisation [%] | | | | Block | | GPC^{b} | | Elektrolumineszenz^{c} | | | |
|---|---|---|---|---|---|---|---|---|---|---|---|---|
| Polymer (Typ)^{a} | Monom.1 | Monom.2 | Monom.3 | Monom.4 | Block | Restpolymer | M_{w} [kDa] | Mₙ [kDa] | CIE x/y^{d} | Max. EII. [Cd/A] | U@ 100 Cd/m² [V] | LT^{e} [h] |
| P1(S) | 50% M1/M2 | 30% M7/M8 | 10% M9 | 10% M19 | altern. M2/M9 | statistisch | 993 | 200 | 0.18/0.28 | 5,60 | 3,3 | 2200 |
| P2(S) | 50% M1/M2 | 20% M7/M8 | 20% M9 | 10%M19 | altern. M2/M9 | satistisch | 392 | 91 | 0,18/0,27 | 5,09 | 3,1 | 2000 |
| P3(S) | 50% M1/M2 | 30% M7 | 10% M11^{f}/BOR1 | 10% M19 | Homo. *M11*/*BOR1* | satistisch | 361 | 96 | 0,18/0,31 | 6,19 | 3,9 | 2700 |
| P4 (S) | 50% M1/M2 | 30% M7/M8 | 10% M11^{f}/BOR1 | 10% M19/BOR2 | Homo. M11/BOR1 | statistisch | 304 | 78 | 0,19/0,32 | 6,31 | 4,0 | 3100 |
| P5(S) | 50% M2 | 20% M7 | 10% M9 | 20% M21 | allern. M2/M9 | tellstatistisch | 296 | 72 | 0,31/0,58 | 11,43 | 2,8 | >5000 |
| P6(S) | 50% M1/M2 | 20% M7 | 10% M11^{f}/BOR1 | 20% M21 | Homo M11/BOR1 | statistisch | 296 (484) | 70 (121) | 0,35/0,58 | 14,73 | 3.1 | >7500 |
| P7(S) | 50% M2 | 35% M12 | 10% M9 | 5% M23 | altern. M2/M9 | teilstatistisch | 149 | 53 | 0,67/0,33 | 2,25 | 3,1 | >8000 |
| P8(S) | 50% M2 | 30% M7 | 10% M19 | 10% M9 | allern. M2/M19 | teilstatistisch | 374 | 125 | 0.19/0.33 | 4.5 | 3,8 | 2000 |
| P9 (S) | 50% M2 | 30% M7 | 10% M19 | 10% M9 | altern. M2/M19 + altern. M2/M9 | teilstastisch | 456 | 107 | 0,18/0,31 | 5,6 | 3,32 | 3600 |
| P9 (S) | 50% M2 | 30% M7 | 10% M19 | 10% M9 | altern. M2/M19 M2/M9 | teilstastisch | 445 | 125 | 0,18/0,30 | 5,4 | 3,23 | 2700 |
| V1 {S} | 50% M1/M2 | 30% M7/M8 | 10% M9 | 10% M19 | ---- | statistisch | 666 | 167 | 0,18/0.29 | 4,84 | 3,9 | 1800 |
| V2 {S} | 50% M1/M2 | 20% M7/M8 | 20% M9 | 10% M19 | --- | statistisch | 561 | 148 | 0,18/0,27 | 4,98 | 3,7 | 1500 |
| V3 {S} | 50% M2 | 30% M7 | 10% M11^{f} | 10% M19 | --- | teilstatistisch | 698 | 228 | 0,17/0,26 | 5,45 | 3,8 | 1300 |
| V4 (S) | 50% M1/M2 | 30% M7/M8 10% | M11^{f}/EM1 | 10%M19/EM3 | --- | statistisch | 509 | 128 | 0,21/0,33 | 5,94 | 3,9 | 1400 |
| V5 (S) | 50% M2 | 20% M7 | 10% M9 | 20% M21 | --- | teilstatistisch | 497 | 140 | 0,28/0,57 | 10,22 | 3,2 | >5000 |
| V6 (S) | 50% M2 | 20% M7 | 10% M11^{f} | 20% M21 | --- | teilstatistish | 624 | 159 | 0.31/0,58 | 8,97 | 2,9 | 2500 |
| V7 (S) | 50% M2 | 35% M12 | 10% M9 | 5% M23 | --- | teilstatistich | 472 | 63 | 0,68/0,32 | 1,92 | 3,5 | >5000 |

| | | | | | | | | | | | | |
|---|---|---|---|---|---|---|---|---|---|---|---|---|
| ^{a}S = Durch Suzuki-Polymerisation hergestellt (vgl. Bsp. P1), ^{b}GPC Messungen THF;1 mL/min, Pigel 10µm Mixed.82 x 300 x 7.5 mm². 35 °C, RI Detektion gegen Polystyrol geeicht ^{c}Zur Herstellung der Polymer LEDs, stelle Teil C. ^{d}CIE-Koordinaten: Chromatizitäls-Koordinaten der Commission Internationale de l'Eclairage von 1931. ^{e}Die angegebene Lebensdauer bezieht sich auf den so genannten LT50-Wert, d.h. die Zeit die verstreicht, bis die entsprechende PLED nur noch 50 % der Arfangsheltigkeit aufweist: die Werte wurden extrapoliert auf eine Anfangshelligkeit von 100 Cd/m². ^{f}Das Monomer M11 ist am nicht-bromierten Phenylring In para-Position zum Stickstoff mit einer *sec*-Butylgruppe substituiert. | | | | | | | | | | | | |

## Patentansprüche

1. Verfahren gemäß Formel (I) zur Herstellung von Aryl- oder (Heteroaryl)amin-Boronsäurederivaten durch HARTWIG-BUCHWALD-Kupplung eines primären oder sekundären Amins in Gegenwart einer Palladiumverbindung, mindestens eines Phosphinliganden und mindestens einer Base, **dadurch gekennzeichnet, dass** die Reaktion mit einer Aryl- oder Heteroaryl-monohalogenidmonoboronsäureester-Verbindung oder einer Aryl- oder Heteroarylmonosulfonat-monoboronsäureester-Verbindung durchgeführt wird: 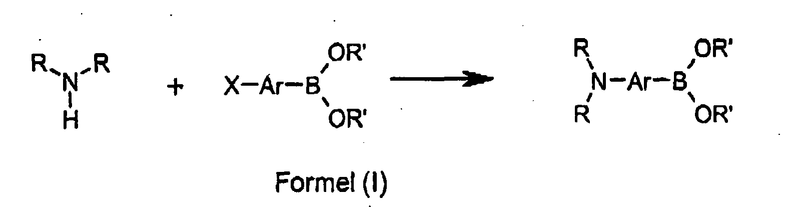 wobei für die verwendeten Symbole gilt:
R ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch N-R', O, S, CO-O, O-CO-O ersetzt sein können, wobei auch ein oder mehrere H-Atome durch Fluor ersetzt sein können, eine Aryl- oder Heteroarylgruppe mit 5 bis 40 C-Atomen, bei der auch ein oder mehrere C-Atome durch O, S oder N ersetzt sein können und welche auch durch einen oder mehrere nicht-aromatische Reste R substituiert sein kann, wobei auch zwei oder mehrere der Reste R miteinander ein Ringsystem bilden können, mit der Maßgabe, dass mindestens einer der Reste R an der Ausgangsverbindung ungleich H ist;
R' ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch O, S, CO-O, O-CO-O ersetzt sein können, wobei auch ein oder mehrere H-Atome durch Fluor ersetzt sein können, eine Aryl- oder Heteroarylgruppe mit 5 bis 40 C-Atomen, bei der auch ein oder mehrere C-Atome durch O, S oder N ersetzt sein können und welche auch durch einen oder mehrere nicht- aromatische Reste R substituiert sein kann; dabei können auch zwei oder mehr Reste R' miteinander ein Ringsystem bilden;
X ist bei jedem Auftreten gleich oder verschieden Cl, Br, I oder O-SO₂R', mit der Vorgabe, dass R' hier ungleich H ist;
Ar ist bei jedem Auftreten gleich oder verschieden eine Arylen- oder Heteroarylengruppe mit 5 bis 40 C-Atomen, bei der auch ein oder mehrere Atome durch O, S oder N ersetzt sein können und welche auch durch einen oder mehrere Reste R' substituiert sein kann.

## Claims

1. Process according to formula (I) for the preparation of aryl- or (heteroaryl)amine-boronic acid derivatives by HARTWIG-BUCHWALD coupling of a primary or secondary amine in the presence of a palladium compound, at least one phosphine ligand and at least one base, **characterised in that** the reaction is carried out with an aryl or heteroaryl monohalide monoboronic acid ester compound or an aryl or heteroaryl monosulfonate monoboronic acid ester compound: 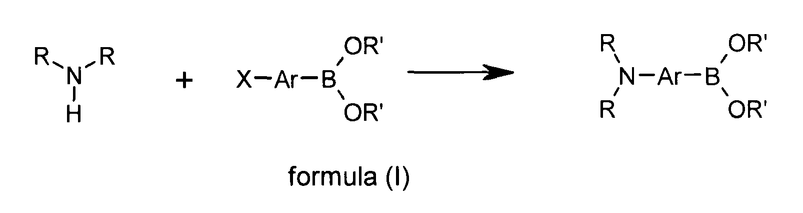 where the following applies to the symbols used:
R is on each occurrence, identically or differently, H, a straight-chain, branched or cyclic alkyl chain having 1 to 22 C atoms, in which, in addition, one or more non-adjacent C atoms may be replaced by N-R', O, S, CO-O, O-CO-O, where, in addition, one or more H atoms may be replaced by fluo- rine, an aryl or heteroaryl group having 5 to 40 C atoms, in which, in addi- tion, one or more C atoms may be replaced by O, S or N and which may also be substituted by one or more non-aromatic radicals R, where, in addition, two or more of the radicals R may form a ring system with one another, with the proviso that at least one of the radicals R on the starting compound is not equal to H;
R' is on each occurrence, identically or differently, H, a straight-chain, branched or cyclic alkyl chain having 1 to 22 C atoms, in which, in addition, one or more non-adjacent C atoms may be replaced by O, S, CO-O, O-CO-O, where, in addition, one or more H atoms may be replaced by fluo- rine, an aryl or heteroaryl group having 5 to 40 C atoms, in which, in addi- tion, one or more C atoms may be replaced by O, S or N and which may also be substituted by one or more non-aromatic radicals R; two or more radicals R' may also form a ring system with one another;
X is on each occurrence, identically or differently, Cl, Br, I or O-SO₂R', with the proviso that R' here is not equal to H;
Ar is on each occurrence, identically or differently, an arylene or heteroarylene group having 5 to 40 C atoms, in which, in addition, one or more C atoms may be replaced by O, S or N and which may also be substituted by one or more radicals R'.

## Revendications

1. Procédé selon la formule (I) de préparation de dérivés d'acide aryl- ou (hétéroaryl)amine-boronique par couplage de HARTWIG-BUCHWALD d'une amine primaire ou secondaire en présence d'un composé de palladium, au moins un ligand phosphine et d'au moins une base, **caractérisé en ce que** la réaction est effectuée avec un composé d'aryl- ou hétéroaryl-monohalogénure ester de l'acide monoboronique ou un composé d'aryl- ou hétéroaryl-monosulfonate ester de l'acide monoboronique : 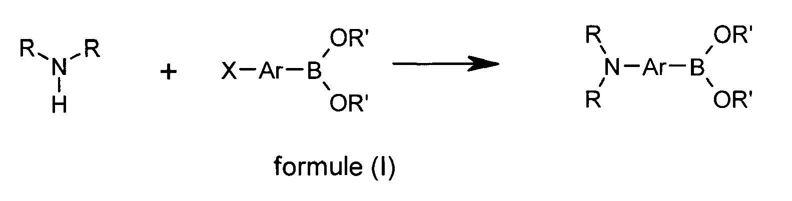 où ce qui suit s'applique aux symboles utilisés :
R est à chaque occurrence, de manière identique ou différente, H, une chaîne alkyle à chaîne linéaire, ramifiée ou cyclique ayant de 1 à 22 atomes de C, où, de plus, un ou plusieurs atomes de C non adjacents peuvent être remplacés par N-R', O, S, CO-O, O-CO-O, où, de plus, un ou plusieurs atomes de H peuvent être remplacés par fluor, un groupement aryle ou hétéroaryle ayant de 5 à 40 atomes de C, où, de plus, un ou plu- sieurs atomes de C peuvent être remplacés par O, S ou N et pouvant être aussi substitués par un ou plusieurs radicaux non aromatiques R, où, de plus, deux radicaux R, ou plus, peuvent former un noyau l'un avec l'autre, à condition qu'au moins l'un des radicaux R sur le produit de départ ne soit pas égal à H ;
R' est à chaque occurrence, de manière identique ou différente, H, une chaîne alkyle à chaîne linéaire, ramifiée ou cyclique ayant de 1 à 22 atomes de C, où, de plus, un ou plusieurs atomes de C non adjacents peuvent être remplacés par O, S, CO-O, O-CO-O, où, de plus, un ou plu- sieurs atomes de H peuvent être remplacés par fluor, un groupement aryle ou hétéroaryle ayant de 5 à 40 atomes de C, où, de plus, un ou plusieurs atomes de C peuvent être remplacés par O, S ou N et pouvant être aussi substitués par un ou plusieurs radicaux non aromatiques R ; deux radicaux R', ou plus, peuvent aussi former un noyau l'un avec l'autre ;
X est à chaque occurrence, de manière identique ou différente, Cl, Br, I ou 0-S0₂R', à condition que R' ne soit pas ici égal à H ;
Ar est à chaque occurrence, de manière identique ou différente, un groupe- ment arylène ou hétéroarylène ayant de 5 à 40 atomes de C, où, de plus, un ou plusieurs atomes de C peuvent être remplacés par O, S ou N et pouvant être aussi substitués par un ou plusieurs radicaux R'.
